# Europäisches Patentamt

# European Patent Office

# Office européen des brevets

(11) Numéro de publication: **0 038 510**
**B1**

(12) **FASCICULE DE BREVET EUROPEEN**

(45) Date de publication du fascicule du brevet:
**10.07.85**

(21) Numéro de dépôt: **81102843.0**

(22) Date de dépôt: **14.04.81**

(51) Int. Cl.⁴: **H 05 K 7/20,** H 01 L 23/44

(54) **Ensemble de semiconducteurs de puissance muni de transformateurs et de circuits d'allumage et de protection.**

(30) Priorité: **21.04.80 FR 8008865**

(43) Date de publication de la demande:
**28.10.81 Bulletin 81/43**

(45) Mention de la délivrance du brevet:
**10.07.85 Bulletin 85/28**

(84) Etats contractants désignés:
**CH DE FR GB IT LI**

(56) Documents cités:
**FR - A - 2 399 781**
**FR - A - 2 413 847**

(73) Titulaire: **ALSTHOM-ATLANTIQUE Société anonyme dite:, 38, Avenue Kléber, F-75784 Paris Cédex 16 (FR)**

(72) Inventeur: **Masselin, Michel, 30, rue du Général Exelmans, F-78140 VELIZY-VILLACOUBLAY (FR)**

(74) Mandataire: **Weinmiller, Jürgen et al, Zeppelinstrasse 63, D-8000 München 80 (DE)**

# Description

La présente invention concerne un ensemble de semi-conducteurs de puissance muni de transformateurs et de circuits d'allumage et de protection lesdits semi-conducteurs étant disposés en colonnes immergées dans un fluide de refroidissement tel qu'un hydrocarbure fluoré. Un tel ensemble est décrit dans la demande FR-A-2 413 847.

Souvent, des colonnes de thyristors et diodes de puissance sont enserrés entre deux plateaux d'extrémité, l'ensemble étant assujetti dans une enceinte étanche contenant de l'hydrocarbure fluoré. Ces semi-conducteurs de puissance sont utilisés pour assurer, par exemple, la commande de moteurs de traction dans la technique ferroviaire. Des transformateurs d'impulsions et des circuits résistances-capacités servent respectivement à l'allumage et à la protection des semi-conducteurs de puissance. En général, les transformateurs d'impulsions et les circuits de protection sont disposés derrière l'un des plateaux à la base des colonnes et dans l'axe des colonnes de semi-conducteurs. Il s'ensuit que les connexions entre les transformateurs d'impulsions et les gâchettes des thyristors sont excessivement longues avec tous les risques de parasites électriques que en résultent. En effet les connexions pour certains des thyristors disposés à l'opposé des transformateurs devaient parcourir toute la longueur de la colonne de semi-conducteurs.

De la demande FR-A-2 399 781 est connu un appareil électrique placé dans une enceinte et refroidi au moyen d'un liquide diélectrique vaporisable d'un volume réduit qui est projeté sur l'appareil au moyen d'une pompe, et dans laquelle les vapeurs sout refroidies à l'aide d'un refroidisseur additionnel.

Le dispositif de support selon la présente invention remédie à cet inconvénient. Les transformateurs sont disposés de telle sorte que les connexions sont plus courtes que dans les dispositifs de l'art antérieur.

La présente invention a pour objet un ensemble de semi-conducteurs de puissance muni de transformateurs et de circuits d'allumage et de protection à résistances et à capacités les semi-conducteurs étant disposés en colonnes immergées dans un fluide de refroidissement lesdites colonnes étant enserrées par des plateaux d'extrémité, lesdits transformateurs et les circuits de protection de résistances-cpacités disposés sur un support, les connexions étant réalisées sous forme de circuits imprimés sur ledit support, caractérisé en ce que lesdits circuits imprimés de support sont groupés dans au moins un plan parallèle aux axes desdites colonnes, et en ce que le niveau du liquide de refroidissement est tel que lesdits transformateurs et lesdites capacités soient en dehors du liquide et que les résistances soient également immergées dans le liquide de refroidissement.

Selon une autre particularité de cette mise en oeuvre lesdits circuits imprimés et/ou de support sont solidarisés desdits plateaux d'extrémité au moyen de tirants assujettis chacun dans la tranche d'un desdits plateaux.

En se référant aux figures ci-jointes on va décrire ci-après un exemple préféré de mise en oeuvre de la présente invention.

La figure 1 représente une coupe schématique transversale d'une enceinte contenant plusieurs ensembles selon l'invention.

La figure 2 représente, en échelle agrandie une vue schématique longitudinale partiellement coupée du même dispositif.

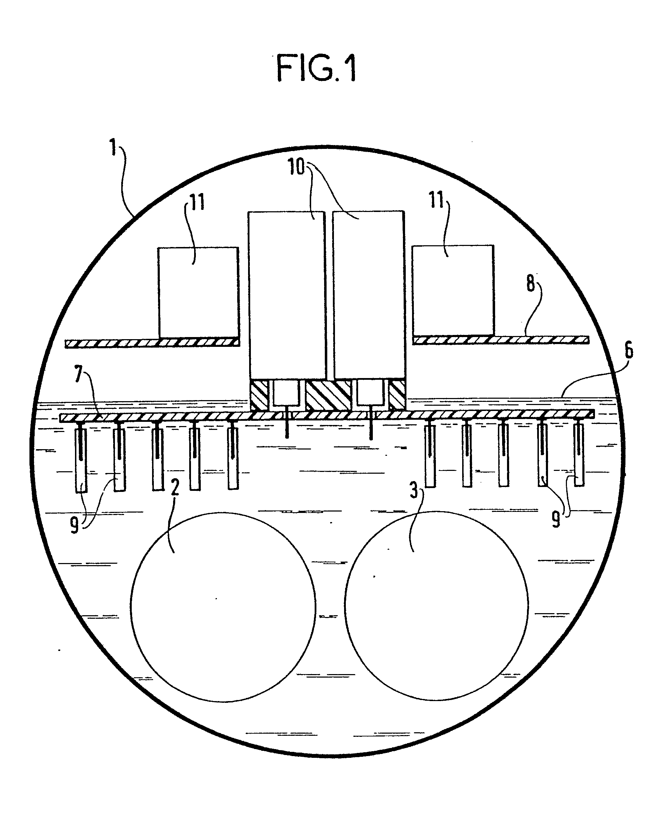

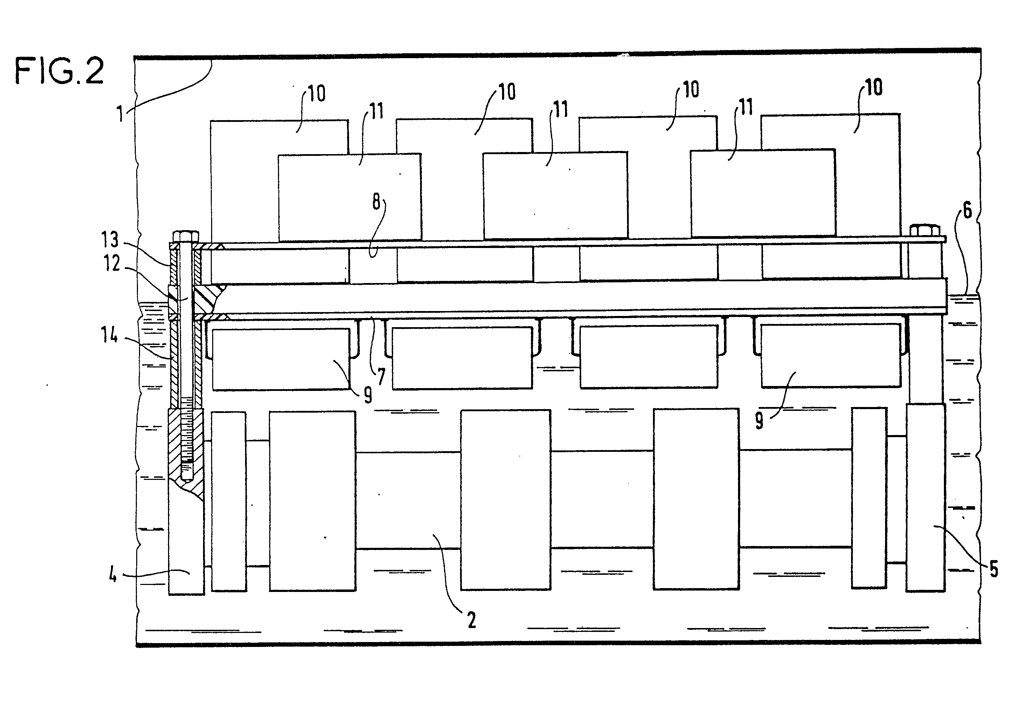

On voit sur la figure 1 une enceinte 1 contenant deux colonnes 2 et 3 de semi-conducteurs par exemple des thyristors de puissance enserrés sous une pression élevée entre deux plateaux d'extrémité 4 et 5 (figure 2). De l'hydrocarbure fluoré en phase liquide ne remplit pas entièrement l'enceinte 1, afin de laisser au dessus de son niveau 6, un espace dans lequel l'hydrocarbure fluoré peut passer à l'état vapeur lorsque les colonnes 2 et 3 des semiconducteurs s'échauffent lors de leur utilisation.

Deux plaquettes 7 et 8 de circuits imprimés servant également de support aux circuits accessoires des thyristors ont pour rôles de réaliser les connexions entre ces circuits. Les circuits de protection comportant une pluralité de résistances telle que 9, des condensateurs tels que 10 réalisant une constante de temps RC et des transformateurs d'impulsions tels que 11 dont le rôle est d'allumer les gâchettes des thyristors des colonnes 2 et 3.

Les résistances 9 baignent dans l'hydrocarbure fluoré alors que les condensateurs 10, les transformateurs d'impulsions 11 et l'une des plaquettes, la plaquette 8, sont disposés au-dessus du niveau 6.

On peut remarquer que les plaquettes 7 et 8 sont disposées dans des plans parallèles aux axes des colonnes 2 et 3. Il en résulte que les connexions de commande de gâchette des thyristors sont très courtes car chacun des transformateurs se trouve à hauteur du thyristor correspondant. De plus la longueur de l'enceinte 1 est réduite dans de notables proportions.

Sur la figure 2, on voit le mode de fixation des plaquettes 7 et 8. Celles-ci sont assujetties sur les tranches des plateaux 4 et 5 au moyen de tirants tels que 12 et d'entretoises 13 et 14.

Les applications de l'invention sont du domaine de l'alimentation des moteurs de traction ferroviaire.

## Revendications

1. Ensemble de semi-conducteurs de puissance muni de transformateurs (11) et de circuits d'allumage et de protection à résistance (9) et capacités (10), les semi-conducteurs étant disposés en colonnes (2, 3) immergées dans un liquide de refroidissement contenu dans une enceinte (1), lesdites colonnes étant enserrées par des plateaux d'extrémité (4, 5, figure 2), les transformateurs (11) et les circuits d'allumage et de protection à résistances et capacités étant disposés sur des supports (7, 8), les connexions étant réalisées sous forme de circuits imprimés sur lesdits supports, caractérisé en ce que les circuits imprimés des supports sont groupés dans au moins un plan parallèle aux axes desdites colonnes (2, 3), et en ce que le niveau (6) du liquide de refroidissement dans l'enceinte (1) est tel que les résistances (9) soient également immergées dans le liquide de refroidissement, et que les transformateurs (11) et les capacités (10) soient en-dehors du liquide de refroidissement.

2. Ensemble selon la revendication 1, caractérisé en ce que lesdits circuits imprimés et le support (7, 8) sont solidarisés desdits plateaux d'extrémité (4, 5) au moyen de tirants (12) assujettis chacun dans la tranche d'un desdits plateaux (4, 5).

**Patentansprüche**

1. Leistungshalbleiteraufbau, der Transformatoren (11) und Zünd- und Schutzschaltkreise mit Widerständen (9) und Kondensatoren (10) aufweist und bei dem die Halbleiter in Säulen angeordnet sind, die in einen eine Kühlflüssigkeit enthaltenden Behälter (1) eingetaucht sind und die zwischen Endplatten (4, 5, Fig. 2) eingespannt sind, wobei die Transformatoren (11) und die Zünd- und Schutzschaltkreise mit Widerständen und Kondensatoren auf Trägern (7, 8) angeordnet sind und die Verbindungen als Druckschaltkreise auf den Trägern ausgebildet sind, dadurch gekennzeichnet, daß die Druckschaltkreise der Träger in mindestens einer zu den Achsen der Säulen (2, 3) parallelen Ebene gruppiert sind und daß der Pegel (6) der Kühlflüssigkeit in dem Behälter (1) so gewählt ist, daß die Widerstände (9) ebenfalls in die Kühlflüssigkeit eingetaucht sind, während die Transformatoren (11) und die Kondensatoren (10) sich außerhalb der Kühlflüssigkeit befinden.

2. Aufbau nach Anspruch 1, dadurch gekennzeichnet, daß die Druckschaltkreise und der Träger (7, 8) durch Spannbolzen (12), die in den stirnseitigen Rand der beiden Platten (4, 5) eingefügt sind, mit den Endplatten (4, 5) fest verbunden sind.

**Claims**

1. An assembly of power semiconductors equipped with transformers (11) and with firing and protection circuits including resistors (9) and capacitors (10), the semiconductors being disposed in columns (2, 3) immersed in a cooling liquid contained in a tank (1), said columns being installed between end plates (4, 5, fig. 2), the transformers (11) and the firing and protection circuits including the resistors and capacitors being disposed on supports (7, 8), the connections being made in the form of printed circuits on said supports, characterized in that the printed circuits of the supports are grouped in at least one plane parallel to the axes of said columns (2, 3) and in that the level (6) of the cooling liquid in the tank (1) is such that the resistors (9) are also immersed in the cooling liquid, whereas the transformers (11) and the capacitors (10) are outside the cooling liquid.

2. An assembly according to claim 1, characterized in that said printed circuits and the support (7, 8) are made integral with said end plates (4, 5) by means of tie rods (12) each of which is fitted into the cut surface of one of said plates (4, 5).

# FIG.1

FIG.2